# EUROPEAN PATENT SPECIFICATION

(11) **EP 1 049 073 B1**
(45) Date of publication and mention of the grant of the patent: **01.12.2004**
(21) Application number: 00303361.0
(22) Date of filing: 20.04.2000
(51) Int. Cl.: G10L 19/10

(54) **Method of operating a vocoder**
Verfahren zum Betrieb eines Sprachkodierers
Procédé d'opération d'un codeur de parole

(30) Priority: 28.04.1999 US 300314
(43) Date of publication of application: 02.11.2000
(73) Proprietor: LUCENT TECHNOLOGIES INC., Murray Hill, New Jersey 07974-0636 (US)
(72) Inventor: Erzin, Engin, Edison, New Jersey 08820 (US); Recchoine, Michael C., Nutley, New Jersey 07110 (US)
(74) Representative: Buckley, Christopher Simon Thirsk

(56) References cited:
- EP-A- 0 714 089
- CAMPBELL JR J P ET AL: "THE FEDERAL STANDARD 1016 4800 BPS CELP VOICE CODER" DIGITAL SIGNAL PROCESSING, ACADEMIC PRESS, ORLANDO,FL, US, vol. 1, no. 3, 1 July 1991 (1991-07-01), pages 145-155, XP000393612 ISSN: 1051-2004
- RECCHIONE M C: "THE ENHANCED VARIABLE RATE CODER: TOLL QUALITY SPEECH FOR CDMA" INTERNATIONAL JOURNAL OF SPEECH TECHNOLOGY, KLUWER, DORDRECHT,, NL, vol. 2, no. 4, 1999, pages 305-315, XP001011504 ISSN: 1381-2416

## Description

### Field of the invention

The present invention relates to vocoders, and more particularly to the representation of the fixed codebook response generated thereby.

### Description of the Background Art

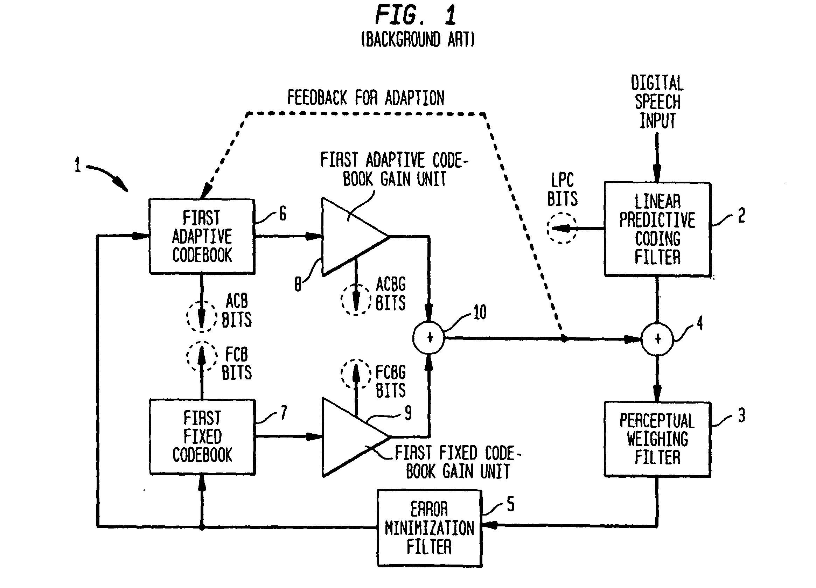

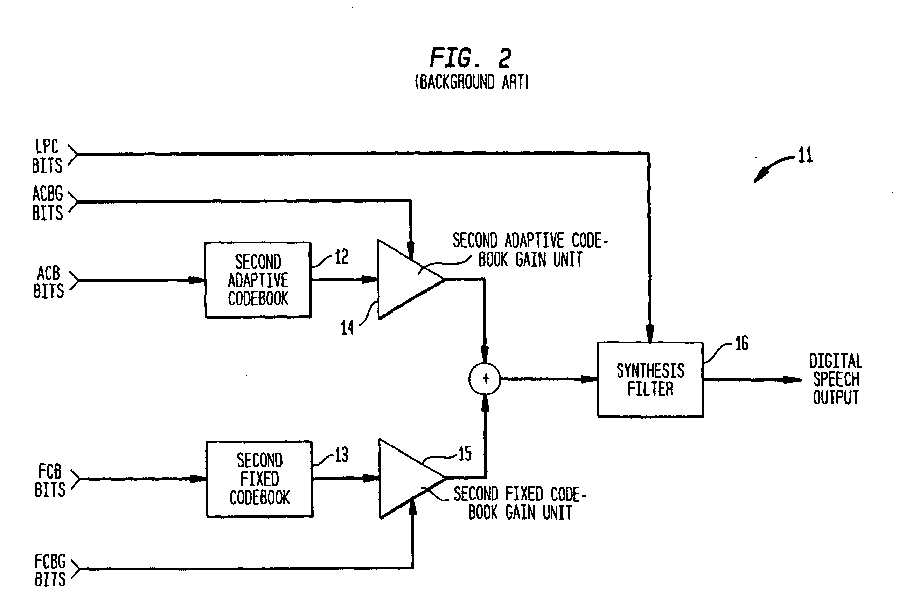

Figures 1 and 2 illustrate transmitting and receiving units of a code excited linear prediction (CELP) vocoder, in accordance with the background art. In Figure 1, the transmitting unit is a first vocoder 1. The first vocoder 1 includes a linear predictive coding (LPC) filter 2. The LPC filter 2 is connected a perceptual weighing filter 3 via a junction 4. The perceptual weighing filter 3 is connected to an error minimization filter 5. The error minimization filter 5 is connected to a first adaptive codebook 6 and a first fixed codebook 7. The first adaptive codebook 6 is connected to a first adaptive codebook gain unit 8. The first fixed codebook 7 is connected to a first fixed codebook gain unit 9. The outputs of the first adaptive codebook gain unit 8 and the first fixed codebook gain unit 9 are connected at a junction 10. The junction 10 is connected to the junction 4.

Generally, the first vocoder 1 sequentially analyzes time segments of a digital speech input. Each time segment is referred to as a signal frame. The vocoder 1 estimates parameters characterizing each signal frame. The parameters are represented by bit patterns, which are assembled into a bit frame. The bit frames can be transmitted more quickly, or stored in less memory, than the signal frames which they represent.

Now, with reference to Figure 1, a general description of the operation of a known IS127 EVRC CDMA type coder (vocoder 1) will be given. For more detail on the operation of the vocoder 1, reference can be made to textbooks relating to digital speech coding. The vocoder 1 is a multi-rate vocoder and has a full rate of operation corresponding to 8 kilobits per second (kbps) and a half rate of operation corresponding to 4 kbps. The digital speech input is divided into signal frames of 20 msec. Each signal frame is further divided into first, second and third sub-frames of approximately 6.6 msec.

When the vocoder 1 operates at full rate, a signal frame passes through the LPC filter 2, which extracts LPC parameters characterizing the entire signal frame and outputs the LPC parameters in the form of twenty-eight LPC bits. The signal frame leaves the LPC filter, passes through the junction 4, the perceptual weighing filter 3 and the error minimization filter 5. The perceptual weighing filter 3 and the error minimization filter 5 do not extract parameter bits from the signal frame, but prepare it for later processing.

Next, the signal frame is received by the first adaptive codebook 6. The first adaptive codebook 6 estimates a pitch for the entire frame, and outputs seven ACB bits characterizing the pitch of the entire frame. Then, the first adaptive codebook gain unit 8 estimates an adaptive codebook gain of the first sub-frame, the second sub-frame and the third sub-frame. Three ACBG bits estimate the adaptive codebook gain of the first sub-frame. Three more ACBG bits estimate the adaptive codebook gain of the second sub-frame. And, still three more ACBG bits estimate the adaptive codebook gain of the third sub-frame.

Next, the signal passes through the junction 10, the junction 4, the perceptual weighing filter 3 and the error minimization filter 5, and is received by the first fixed codebook 7. The first fixed codebook 7 estimates the random, unvoiced characteristics of the first sub-frame, the second sub-frame, and the third sub-frame. Thirty-five FCB bits represent the fixed codebook response for the first sub-frame. Thirty-five more FCB bits represent the fixed codebook response for the second sub-frame. And, still thirty-five more FCB bits represent the fixed codebook response for the third sub-frame.

Next, the first fixed codebook gain unit 9 estimates a fixed codebook gain of the first sub-frame, the second sub-frame and the third sub-frame. Five FCBG bits estimate the fixed codebook gain of the first sub-frame. Five more FCBG bits estimate the fixed codebook gain of the second sub-frame. And, still five more FCBG bits estimate the fixed codebook gain of the third sub-frame.

At this point, all of the bit patterns (LPC, ACB, ACBG, FCB, FCBG) are assembled into the bit frame. The bit frame, representing the signal frame, is complete and can be transmitted to a second vocoder 11 for synthesis, or stored in a memory for later retrieval. The above process sequentially repeats itself for each signal frame of the digital speech input.

Figure 2 illustrates a decoding section of the second vocoder 11 for synthesizing the bit frames. The second vocoder 11 includes a second adaptive codebook 12, a second fixed codebook 13, a second adaptive codebook gain unit 14, a second fixed codebook gain unit 15, and a synthesis filter 16. The second vocoder 11 receives the LPC bits, ACB bits, ACBG bits, FCB bits and FCBG bits. These bits are used by the second vocoder 11 to reconstruct an estimate of the original signal frame, in a manner well known in the art.

The total number of bit positions within the bit fame allocated to the various parameters, as given above, relate to the vocoder 1 (IS127 EVRC CDMA coder) operating at a full rate of 8 kbps. To summarize, the bit frame would include: 28 LPC bits; 7 ACB bits; 3+3+3=9 ACBG bits; 35+35+35=105 FCB bits; and 5+5+5=15 FCBG bits. Therefore, the total number of bits in the bit frame would be 164 bits.

As mentioned above, the vocoder 1 is a multi-rate vocoder, and the half rate of the vocoder 1 is 4 kbps. When the vocoder 1 operates at the half rate, it is no longer possible to transmit bit frames having a size of one hundred and sixty-four bit positions, while still keeping up with an incoming digital speech input, in real time. Instead, the bit frame size must be reduced to approximately eighty bit positions.

When the vocoder 1 (IS 127 EVRC CDMA coder) operates at its half rate (4 kbps), the bit position are rationed in the following order: 22 LPC bits; 7 ACB bits; 3+3+3=9 ACBG bits; 10+10+10=30 FCB bits; and 4+4+4=12 FCBG bits. Therefore, the total number of bits in the bit frame would be 80 bits. It can be seen that the FCB bits suffer the predominate share of the bit frame's reduction in size.

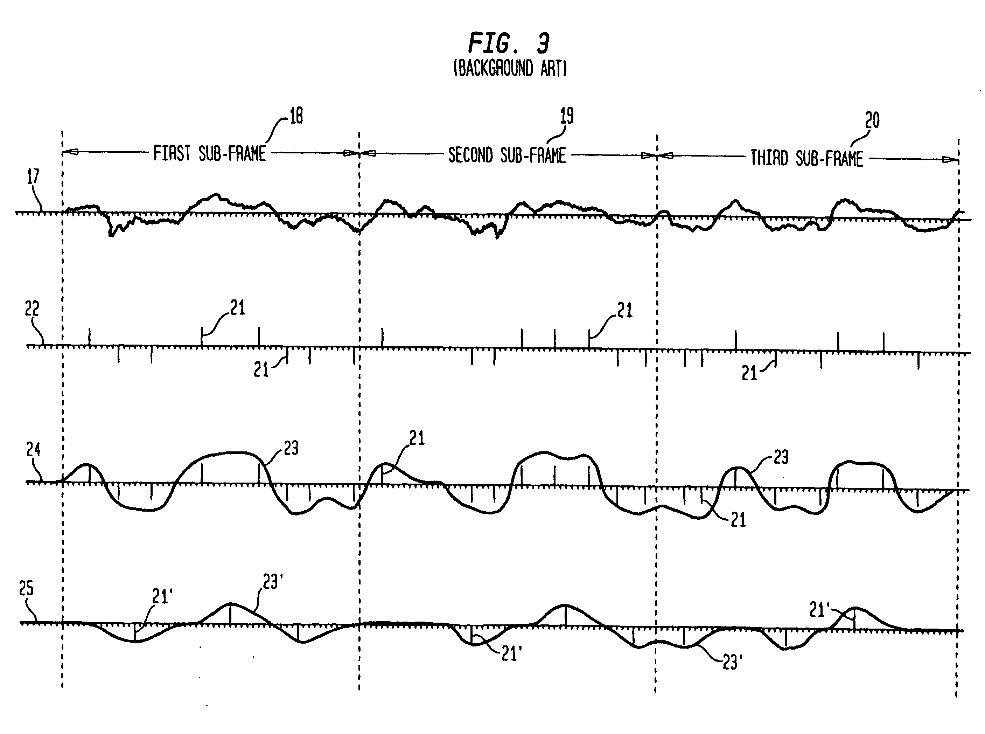

Since the present invention concerns the fixed codebook, a brief summary of the operation of the fixed codebook computation in the vocoder 1 is in order. In the full rate (8 kbps), the one hundred and five bit positions allocated toward representing the fixed codebook response for the frame have the ability of placing eight estimation pulses in each of the three sub-frames. Graphically this is represented in Figure 3.

In Figure 3, a first signal line 17 is illustrative of a second residual signal presented to the fixed codebook 7 for estimation. The first sub-frame 18 is divided into fifty-three sample points, the second sub-frame 19 is also divided into fifty-three sample points, and the third sub-frame 20 is divided into fifty-four sample points.

In order to best estimate the characteristics of the second residual signal on signal line 17, positive and/or negative pulses 21 are located at select ones of the sample points. For example, second signal line 22 illustrates the polarities and placements of the pulses 21, in estimating the second residual signal of first signal line 17. The placements and polarities are the data characterized by the FCB bits for each of the sub-frames 18, 19, 20. In other words, for each sub-frame, the fixed codebook 7 estimates the best placement of eight to ten pulses 21 to represent the second residual signal of the first signal line 17, and the FCB bits for that sub-frame identify the placements and polarities of the pulses 21.

When the second vocoder 11 receives the FCB bits, an envelope 23 can be mathematically constructed based upon the placement of the positive and negative pulses 21 in order to provide an estimation to the second residual signal of the first signal line 17. Graphically this is illustrated on third signal line 24. Of course, the FCBG bits of each of the sub-frames would influence the amplitude of the peaks and valleys of the envelope 23 within the respective sub-frames, so that the amplitudes of the peaks and valleys of the envelope 23 match the average amplitude of the actual peaks and valleys within the second residual signal.

When the vocoder 1 operates at full rate (8 kbps), the one hundred and five bit positions within the bit frame, allocated to the fixed codebook response, can represent the positions and polarity of eight pulses per sub-frame, as illustrated by the second and third signal lines 22 and 24. When the vocoder 1 operates at half rate (4 kbps), the thirty bit positions within the frame, allocated to the fixed codebook response, can only represent the positions and polarity of three pulses per sub-frame.

A fourth signal 25 illustrates the placement of the positive and negative pulses 21 when the vocoder 1 operates at its half rate and the envelope 23' constructed mathematically in accordance with the placement of the pulses 21'. It can clearly be seen that the envelope 23' developed during the half-rate of operation does not approximate the second residual signal of the first signal line 17, nearly as well as, the envelope 23 developed when the vocoder 1 operates at its full rate.

It has been observed that the first and second vocoders 1, 11 process digital speech with sufficient reproduction quality when a medium to high bit rate is used during transmission of the bit frames (e.g. 4.8 kbps to 16 kbps). However, when bit rates are below 4.8 kbps (such as the 4 kbps rate, corresponding to the half-rate), the quality of the synthesized speech suffers greatly. The poor quality is primarily due to the inaccurate representation of the fixed codebook response of the sub-frames, as illustrated by the fourth signal line 25 in Figure 3.

The poor representation is the result of the limited number of bits (e.g. thirty bits) allocated within the bit frame to represented the fixed codebook response of all of the sub-frames. Since the bit frame size cannot be increased when the bit rate is low, there exists a need in the art for a vocoder, and method of operating a vocoder, which can more accurately represent a fixed codebook response of a signal frame, or sub-frames, while doing so with a limited number of bit positions within the bit frame.

EP-A-0 714 098 is directed to a code-excited linear prediction (CELP) coder and CELP decoder suitable for use in a telephone answering machine. In general, CELP employs excitation signals drawn from a codebook. The CELP coder finds the optimum excitation signal by making an exhaustive search of its codebook, then outputs a corresponding index value. A CELP decoder accesses an identical codebook by this index value and reads out the excitation signal.

### Summary Of The Invention

A method according to the invention is as set out in claim 1. Preferred forms are set out in the dependent claims.

A vocoder, in accordance with the present invention, includes a fixed codebook having a plurality of entries of pulse sequences for comparison to a residual signal of the signal frame or sub-frame. The entries of the fixed codebook are tailored to the signal frame or sub-frame being encoded. A noise signal is stored in a transmitting vocoder. During encoding, the noise signal is shaped by filtering dependent upon determined parameters which characterize the signal frame or sub-frame. The shaped noise signal is passed though a thresholding filter to arrive at a pulse sequence. The fixed codebook response is chosen as that portion (i.e. entry) of the pulse sequence which best matches the residual signal of the signal frame or sub-frame. The indexed location of that portion is designated as the fixed codebook bits which are included within the bit frame. An identical noise signal is also stored in a decoding vocoder. The same active filtering and threshold filtering are applied to the identical noise signal to arrive at a same pulse sequence. Therefore, the fixed codebook bits, of the bit frame, will index the proper portion of the pulse sequence which represents the fixed codebook response to be used during synthesis.

### Brief Description Of The Drawings

The exemplary embodiments of present invention will become more fully understood from the detailed description given herein below and the accompanying drawings which are given by way of illustration only, and thus are not limitative of the exemplary embodiments of the present invention. In the Figures, like elements have been assigned the same reference numerals.
Figure 1 illustrates a transmitting vocoder, in accordance with the background art;
Figure 2 illustrates a decoding section of a vocoder, in accordance with the background art;
Figure 3 illustrates various signals associated with an exemplary embodiment of the fixed codebook response, in accordance with the background art;
Figure 4 illustrates a transmitting vocoder, in accordance with the present invention;
Figure 5 illustrates a comparison of a second residual signal to various pulse sequences to determine a fixed codebook response;
Figure 6 illustrates a fixed code codebook shaping unit used to arrive of the possible fixed codebook responses;
Figure 7 illustrates various signals associated with the fixed codebook shaping unit; and
Figure 8 illustrates a decoding section of a vocoder, in accordance with an exemplary embodiment of the present invention.

### Detailed Description Of The Exemplary Embodiments

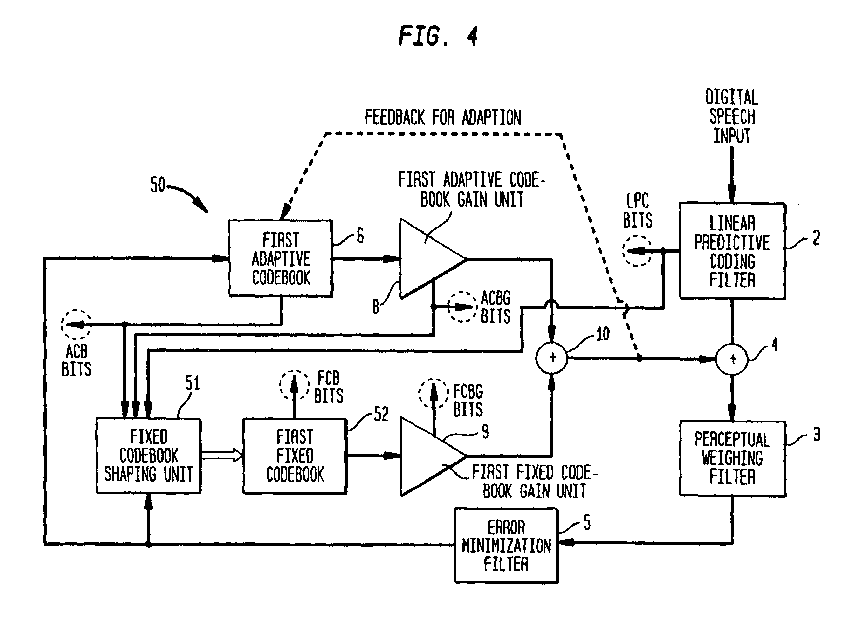

Figure 4 illustrates a transmitting, first vocoder 50, in accordance with an exemplary embodiment the present invention. The vocoder 50 includes an LPC filter 2, a perceptual weighing filter 3; the error minimization filter 5; the first adaptive codebook 6; the first adaptive codebook gain unit 8; and the first fixed codebook gain unit 9. Of particular interest is the first fixed codebook shaping unit 51 and the modified, first fixed codebook 52, in accordance with the present invention. The first fixed codebook shaping unit 51 is connected to the first fixed codebook 52, and receives inputs including the LPC bits, ACB bits, and ACBG bits.

The method of operation of the first vocoder 50 corresponds to the method described above except in relation to the fixed codebook response estimations. When the first sub-frame 18 is being estimated, instead of determining the best placement of three pulses 21', the second residual signal (signal line 17) is compared to a plurality of possible pulse sequences to determine which one of the pulse sequences best matches the second residual signal.

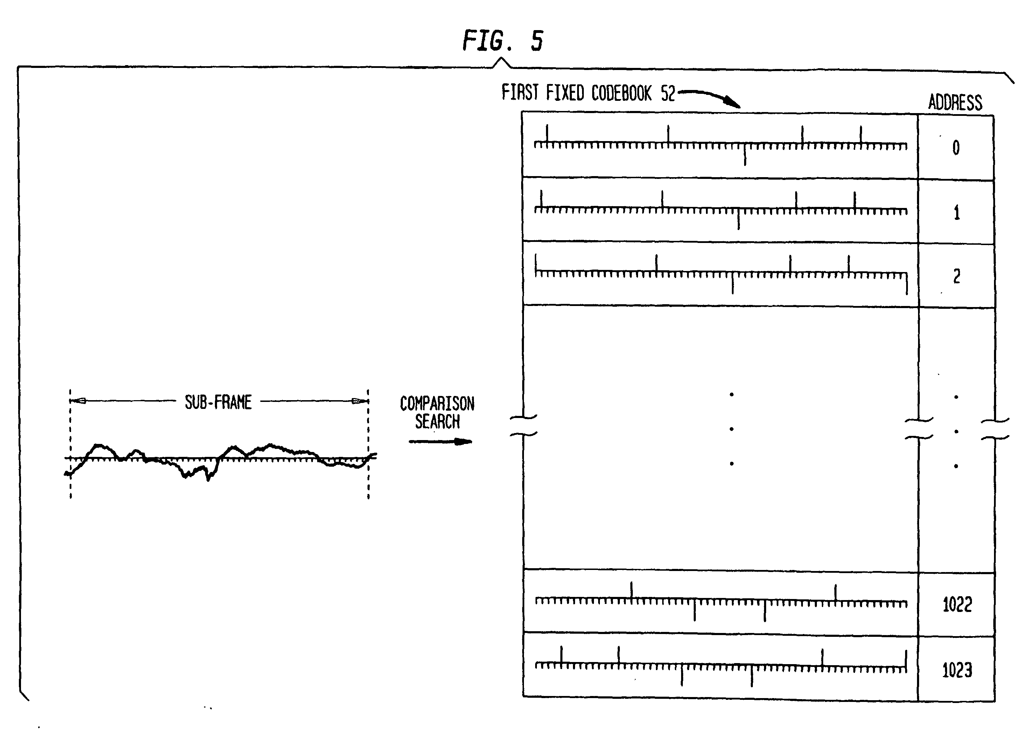

Graphically, this comparison is illustrated in Figure 5. Since ten bit positions are allocated toward the representation of the fixed codebook response of a given sub-frame, the first fixed codebook 52 will have 1024 (2^10=1024) possible pulse sequences to compare to the second residual signal. The comparisons are made and the best matching sequence is determined, then the address of the best matching sequence is considered the FCB bits for the sub-frame, as will be more fully described hereinbelow.

Since only 1,024 various pulse sequences are compared by the first fixed codebook 52, it is important that the sequences be carefully selected, so that as close a match as possible can be found. By the present invention, it has been discovered that the fixed codebook response of a given sub-frame bears a correspondence, or relationship, to the LPC bits, ACB bits, and ACBG bits characterizing that sub-frame. Based upon this discovery, the present invention provides the first fixed codebook shaping unit 51 which generates the possible sequences of the first fixed codebook 52 prior to estimation of the fixed codebook response for the sub-frame.

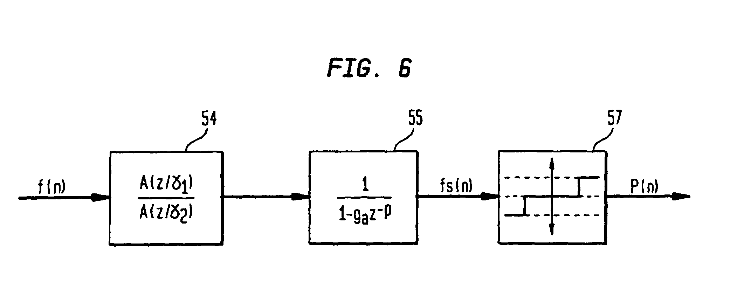

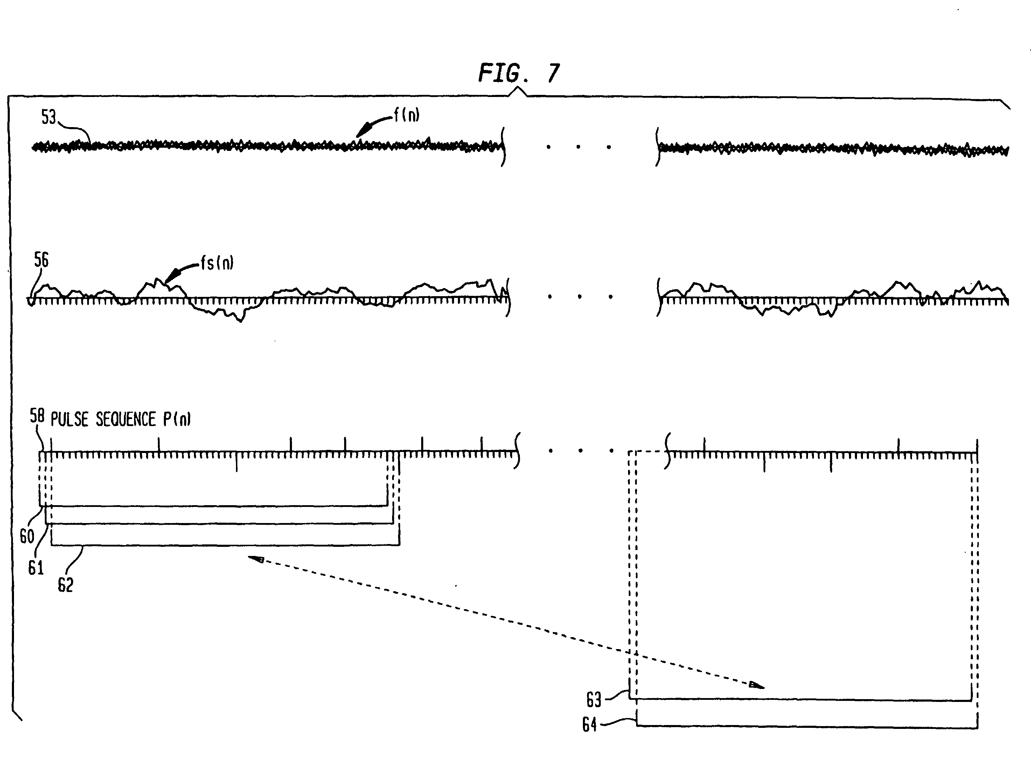

Now, the operation of the first fixed codebook shaping unit 51 will be described with reference to Figures 6 and 7. The first fixed codebook shaping unit 51 has a uniformly distributed, random noise f(n) stored therein, as illustrated on signal line 53. The random noise f(n), such as a Gaussian distributed random noise, has a flat spectrum. The random noise f(n) is passed through a linear predictive (LP) weighing filter 54 and a pitch sharpening filter 55. The filters 54 and 55 are active filters, meaning their operation upon a signal is controlled by inputs. The filters 54 and 55 modify the random noise f(n) to produce an output signal fs(n), as illustrated on signal line 56. The output signal fs(n) has extenuated peaks. In other words, the random noise f(n) has been spectrally shaped by the filters 54 and 55, in accordance with the parameters determined by the LPC filter 2, the first adaptive codebook 6 and the first adaptive codebook gain unit 8.

The operation of the LP weighing filter 54 and the pitch sharpening filter 55 are governed by equations involving the LPC bits, ACB bits and ACBG bits. The equations are illustrated in Figure 6, where A(z) represents the output of the LPC filter 2; gₐ is the quantitized ACB gain; and P is the pitch lag (as determined by the adaptive codebook 6). In essence, the LP weighing filter 54 is broadening the poles by ?₁ and ?₂ factors.

The LP weighing filter 54 and pitch sharpening filter 55 are commonly used filters. The equations and operational characteristics of the filters are known. However, the use of the LP weighing filter 54 and pitch sharpening filter 55 in a combination as disclosed in the present invention is unknown to the art. For more information on the LP weighing filter 54 and pitch sharpening filter 55, reference can be made to textbooks on the subject, such as "Speech Coding and Synthesis," by W.B. Kleijn et al., Elsevier Press, 1995, pp. 89-90.

The output fs(n) of the pitch sharpening filter 55 is passed through a nonlinear thresholding filter 57 to arrive at a pulse sequence P(n), as illustrated on signal line 58. The thresholding filter 57 has an adjustable upper threshold and lower threshold. All occurrences of the signal fs(n) between the thresholds are set equal to zero. Occurrences of the signal fs(n) above the upper threshold for a predetermined duration earns a positive pulse 21'', and likewise occurrences of the signal fs(n) below the lower threshold for a predetermined duration earns a negative pulse 21''.

The sparcity of the pulses 21'' can be controlled by the setting of the upper and lower thresholds of the thresholding filter 57. For example, if the thresholds are close together, i.e. close to the zero, many pulses 21'' will occur in the pulse sequence P(n). If the thresholds are set relative far apart, i.e. further away from zero, very few pulses 21'' will occur in the pulse sequence P(n). By the exemplary embodiment of the present invention, it has been determined that the sparcity should preferable be set to in the approximate range of 85 %to 93%, meaning that 85% to 90% of the samples should be equal to zero, leaving some four to seven pulses per sub-frame.

If the exemplary embodiment of the present invention maintains the fifty-three to fifty-four samples per sub-frame, as illustrated in Figure 3, the random noise f(n), stored in the fixed codebook shaping unit 51, lasts for 54+1024=1078 samples, with 6.7 msec sub-frames this would translate into approximately a 133 msec time duration. The fixed codebook response possibilities are determined by a window (also referred to as a vector), fifty-four samples wide, which is shifted over the pulse sequence P(n).

The zero placement of the window is illustrated by reference numeral 60. The pulse sequence immediately above the window 60 is represented by the indexed entry (0) by the first fixed codebook 52 (See Figure 5). The first shifted placement of the window is illustrated by reference numeral 61. The pulse sequence immediately above the window 61 is represented by the indexed entry (1) by the first fixed codebook 52. The second shifted placement of the window is illustrated by reference numeral 62. The pulse sequence immediately above the window 62 is represented by the indexed entry (2) by the first fixed codebook 52. The shifting window process is repeated until the last shifted window 63 representing indexed entry (1023) is determined by the first fixed codebook 52.

It would also be possible to have a random noise f(n) with a 2156 sample duration. In this case, the window, or vector, would be shifted in increments of two samples to arrive at the 1,024 possible sequences for the fixed codebook. In fact, it is possible to carry this pattern even further by extending the duration of the random noise and increasing the incremental stepping of the window.

The fixed codebook response for the first sub-frame 18 is determined to be the pulse sequence which best matches the first sub-frame's second residual signal. The index of that entry (which is equates to the number of shifted positions of the window along the pulse sequence P(n)) will be the FCB bits for the first sub-frame 18. Then, new pulse sequences for the first fixed codebook 52 can be formulated and the second sub-frame 19 will have its fixed codebook response determined. Then, new pulse sequences for the first fixed codebook 52 can again be formulated and the third sub-frame 20 will have its fixed codebook response determined.

It should be noted that a variation of the exemplary embodiment of the present invention would be to only determine new pulse sequences for the first fixed codebook 52, periodically. For instance, new pulse sequences could be formulated only for each new signal frame, as opposed to each new sub-frame, this is in fact a preferred embodiment of the present invention. Alternatively, new entries could be formulated for every other signal frame, etc. By limiting the re-formulation of the fixed codebook's pulse sequences to every signal frame, or every other signal frame, the computations involved are simplified. Further, the reuse of the fixed codebook's pulse sequences is usually sufficiently accuracy in estimating the fixed codebook response, since speech will not tend to significantly vary in the brief time durations involved.

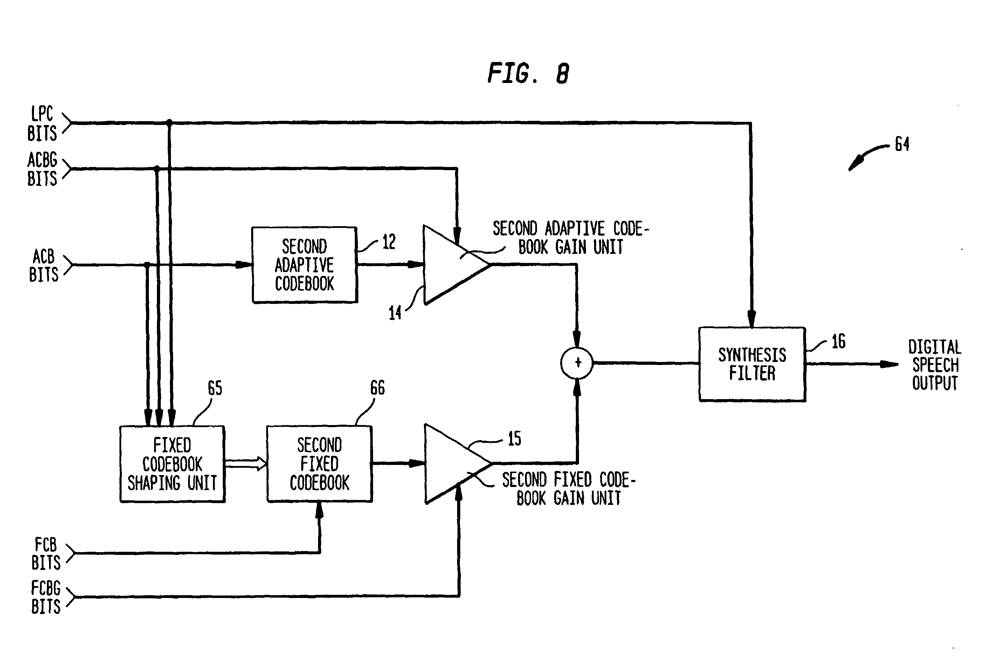

Figure 8 illustrates the decoding section of the receiving, second vocoder 64. The second vocoder 64 includes the second adaptive codebook 12, the second adaptive codebook gain unit 14, the second fixed codebook gain unit 15, and the synthesis filter 16. Of particular interest is the second fixed codebook shaping unit 65 and the modified, second fixed codebook 66, in accordance with the present invention.

The operation of the second fixed codebook shaping unit 65 is the same as the first fixed codebook shaping unit 51 of the first vocoder 50. Inside the second fixed codebook shaping unit 65 is stored an identical copy of the random noise f(n), illustrated on signal line 53 of Figure 7. The second fixed codebook shaping unit 65 includes identical active filters 54 and 55, as well as the identical thresholding filter 57 with the upper and lower thresholds set equal to the upper and lower thresholds of the thresholding filter 57 located in the first fixed codebook shaping unit 51. Therefore, the second fixed codebook shaping unit 65 can generate a pulse sequence P(n) having a sample duration of 1,078 samples, which is identical to the pulse sequence P(n) previously generated in the first fixed codebook shaping unit 51, and illustrated on signal line 58 in Figure 7.

Once the pulse sequence P(n) is generated, the second fixed codebook 66 can determine the fixed codebook response by shifting a fifty-four sample length window a number of positions along the pulse sequence P(n) equal to the index represented by the FCB bits. The portion of the pulse sequence P(n) located immediately above the shifted window will be the proper estimation of the fixed codebook response determined by the first vocoder 50. All other aspects of the second vocoder's synthesis of the signal frame are in accordance with the background art's decoding vocoder 11, illustrated in Figure 2.

It should be noted that the pulse sequence entries in the first fixed codebook 52, available to estimate the second residual signal, could each include some four to seven pulses. This is quite an improvement over the background art's three pulses per sub-frame estimation of the second residual signal. This improvement translates into a noticeable improvement in the quality of the reproduced speech.

A feature of the exemplary embodiment of the present invention, which allows the placement of the four to seven pulses per sequence in the first fixed codebook 52, is the fact that the pulse sequence P(n), from which the entries are taken, is constructed in accordance with other determined parameters of the signal being modeled. By the present invention, it has been discovered that other determined parameters, such as the LPC parameters, ACB parameters, and ACBG parameters bear a relation, or correlation, to the anticipated fixed codebook response. Therefore, these parameters can be used to shape the pulse sequences available to a limited size, fixed codebook, so that the possible pulse sequences will have a relatively high likelihood of matching the second residual signal when an analysis is performed.

If the pulse sequences, having four to seven pulses, were simply randomly generated, the limited size of the fixed codebook (1024 possible sequences) would statistically be insufficient to provide a suitable matching pulse sequence to the vast majority of the continually varying second residual signals. In other words, if each of the 1024 possible pulse sequences had its four to seven pulses randomly placed along the sequence, the best matching pulse sequence to the second residual signal, as determined by the fixed codebook, would most likely be a poor match, and the reproduced speech for that frame, or sub-frame, or be inaccurate.

It should be noted that the second vocoder 64 need not receive any extraneous data, in order to reconstruct the pulse sequence P(n) used by the first fixed codebook 52. The LPC bits, ACB bits, and ACBG bits, which are used in the reconstruction of the pulse sequence P(n) were already needed by the second vocoder 64 in order to reconstruct the speech signal, therefore no extraneous data is being included in the bit frames.

Throughout the disclosure and drawings reference has been made to pulses placed at sample points within sub-frames. It should be readily apparent that such illustrations are merely graphical representations of mathematical operations and equations. The graphical representations should simplify the disclosure in presenting the distinctions between the background art and the present invention. In practice, the fixed codebooks 52 and 66, and fixed codebook shaping units 51 and 65 would process the underlying mathematical operations and equations which underlie the graphical representations.

Also, the exemplary embodiments of the present invention have illustrated the first and second fixed codebook shaping units 51 and 65 as separate components from the first and second fixed codebooks 52 and 66. The separate illustrations have been made to simplify the presentation of the disclosure. In practice, a fixed codebook shaping unit and a fixed codebook could be incorporated into a single physical component. Further, the other illustrated, "black box" components within the vocoders 50 and 64 may be combined so that one physical component could perform one or more of the tasks or operations associated with several of the illustrated "black box" components. For example, the weighing filter 54 can be combined with the pitch sharpening filter 55 and the thresholding filter 57 to form a single component, accomplishing the operations which have been illustrated separately for purposes of explanation.

While the IS 127 EVRC CDMA coder has been described in the background art for comparison purposes, it should be appreciated that the exemplary embodiments of the present invention could be used to improved the performance of any vocoder regardless of the components used in the vocoder and/or the operation of the vocoder. Moreover, while exemplary embodiments of the present invention may be useful in improving the performance of a vocoder, when operated at a low bit rate, it should be appreciated that the exemplary embodiments of the present invention could be used to improve the estimation accuracy of vocoders operating at medium and high bit rates.

The specific values used in the specification above should not be construed as limiting to the present invention. The specific values have been provided merely to facilitate a complete understanding of exemplary embodiments of the present invention. It should be appreciated that the exemplary embodiments of the present invention may be beneficial in vocoder's operating at values besides those specifically used in the example of the specification. For instance, signal frames could be longer or shorter than 20 msec in duration. The signal frames could have more or less sub-frames than three, or no sub-frames at all. Any number of samples could be taken in a sub-frame besides fifty-three or fifty-four.

## Claims

1. A method of operating a vocoder, comprising the steps of:
providing a fixed codebook (52) and a predetermined signal (53);
receiving an input signal for processing by the vocoder;
extracting at least one parameter characterizing the input signal;
altering the predetermined signal (53) in relation to the extracted at least one parameter to arrive at an altered signal (58); **characterized by**
determining a portion (60,61,62,63,64) of the altered signal (58) to represent a fixed codebook response for at least a portion of the input signal.

2. The method according to claim 1, wherein said determining step includes comparing a residual signal of at least a portion of the input signal to various portions of the altered signal and determining which of the various portions best matches the residual signal.

3. The method according to claim 1, wherein the predetermined signal is a Gaussian random noise signal.

4. The method according to claim 1, wherein an indexed location of the portion of the altered signal is **characterized by** a bit pattern and included in a bit frame representing the input signal.

5. The method according to claim 1, further comprising providing a perceptual weighing filter, wherein the altering step includes passing the predetermined signal through the perceptual weighing filter.

6. The method according to claim 5, wherein the perceptual weighing filter is an active filter influenced by a linear predictive coding output characterizing at least a portion of the input signal.

7. The method according to claim 1, further comprising providing a pitch sharpening filter, wherein the altering step includes passing the predetermined signal through the pitch sharpening filter.

8. The method according to claim 7, wherein the pitch sharpening filter is an active filter influenced by an adaptive codebook output and an adaptive codebook gain output, each characterizing at least a portion of the input signal.

9. The method according to claim 1, further comprising the step of filtering the altered signal with a thresholding filter prior to said determining step.

10. The method according to claim 1, further comprising providing a perceptual weighing filter, a pitch sharpening filter and a thresholding filter, wherein said altering step includes passing the predetermined signal through the perceptual weighing filter, the pitch sharpening filter and the thresholding filter.

11. The method according to claim 1, wherein the providing step includes providing at least one parameter extracting unit for performing the extracting step, the at least one parameter extracting unit includes a linear predictive coding unit, and the at least one parameter is represented by linear predictive coding bits.

12. The method according to claim 1, wherein the at least one parameter extracting unit includes an adaptive codebook unit, and the at least one parameter is represented by adaptive codebook bits.

13. The method according to claim 1, wherein the at least one parameter extracting unit includes an adaptive codebook gain unit, and the at least one parameter is represented by adaptive codebook gain bits.

14. The method according to claim 1, wherein the providing step includes providing at least one parameter extracting unit for performing the extracting step, the at least one parameter extracting unit includes a linear predictive coding unit, an adaptive codebook unit, and an adaptive codebook gain unit and the at least one parameter includes parameters represented by linear predictive coding bits, adaptive codebook bits and adaptive codebook gain bits.

15. The method according to claim 1 wherein:
the receiving step includes receiving a bit frame for processing by the vocoder;
the step of altering includes altering a predetermined signal in relation to first bits within the frame to arrive at the altered signal; and the method further comprises:
indexing a portion of the altered signal based on second bits within the frame; and
determining the indexed portion to represent the fixed codebook response for at least a portion of the bit frame.

16. The method according to claim 15, wherein the first bits represent the linear predictive coding response for at least a portion of the bit frame.

17. The method according to claim 15, wherein the first bits represent the linear predictive coding response, an adaptive codebook response and adaptive codebook gain response for at least a portion of the bit frame.

18. The method according to claim 15, wherein the indexed portion is a pulse sequence.

19. The method according to claim 18, wherein the pulse sequence includes a plurality of zero entries and a plurality of pulse entries, and the ratio of zero entries to pulse entries is in the range of 85 to 95 percent.

20. The method according to claim 15, wherein said bit frame includes sub-frames, and the indexed portion is representative of the fixed codebook response for one of the sub-frames of the bit frame.

## Patentansprüche

1. Verfahren zum Betrieb eines Vocoders, mit den folgenden Schritten:
Bereitstellen eines Festcodebuchs (52) und eines vorbestimmten Signals (53);
Empfangen eines durch den Vocoder zu verarbeitenden Eingangssignals;
Extrahieren mindestens eines das Eingangssignal charakterisierenden Parameters;
Abändern des vorbestimmten Signals (53) in bezug auf den extrahierten mindestens einen Parameter, um zu einem abgeänderten Signal (58) zu kommen; **gekennzeichnet durch**
Bestimmen eines Teils (60, 61, 62, 63, 64) des abgeänderten Signals (58), um eine Festcodebuchantwort für mindestens einen Teil des Eingangssignals zu repräsentieren.

2. Verfahren nach Anspruch 1, wobei der Schritt des Bestimmens das Vergleichen eines Restsignals mindestens eines Teils des Eingangssignals mit verschiedenen Teilen des abgeänderten Signals und das Bestimmen, welcher dieser verschiedenen Teile am besten mit dem Restsignal übereinstimmt, umfaßt.

3. Verfahren nach Anspruch 1, wobei das vorbestimmte Signal ein Gaußsches Zufallsrauschsignal ist.

4. Verfahren nach Anspruch 1, wobei eine indizierte Stelle des Teils des abgeänderten Signals durch ein Bitmuster gekennzeichnet und in einem das Eingangssignal repräsentierenden Bitrahmen enthalten ist.

5. Verfahren nach Anspruch 1, bei dem weiterhin ein wahrnehmungsbezogenes Gewichtungsfilter bereitgestellt wird, wobei der Schritt des Abänderns das Leiten des vorbestimmten Signals durch das wahrnehmungsbezogene Gewichtungsfilter umfaßt.

6. Verfahren nach Anspruch 5, wobei das wahrnehmungsbezogene Gewichtungsfilter ein Aktivfilter ist, das durch eine linear-prädiktive Codierungsausgabe beeinflußt wird, die mindestens einen Teil des Eingangssignals charakterisiert.

7. Verfahren nach Anspruch 1, bei dem weiterhin ein Tonhöhenverschärfungsfilter bereitgestellt wird, wobei der Schritt des Abänderns das Leiten des vorbestimmten Signals durch das Tonhöhenverschärfungsfilter umfaßt.

8. Verfahren nach Anspruch 7, wobei das Tonhöhenverschärfungsfilter ein Aktivfilter ist, das durch eine Ausgabe eines adaptiven Codebuchs und eine Verstärkungsausgabe eines adaptiven Codebuchs beeinflußt wird, die jeweils mindestens einen Teil des Eingangssignals charakterisieren.

9. Verfahren nach Anspruch 1, weiterhin mit dem Schritt des Filterns des abgeänderten Signals mit einem Schwellenwertfilter vor dem Bestimmungsschritt.

10. Verfahren nach Anspruch 1, bei dem weiterhin ein wahrnehmungsbezogenes Gewichtungsfilter, ein Tonhöhenverschärfungsfilter und ein Schwellenwertfilter bereitgestellt werden, wobei der Schritt des Abänderns das Leiten des vorbestimmten Signals durch das wahrnehmungsbezogene Gewichtungsfilter, das Tonhöhenverschärfungsfilter und das Schwellenwertfilter umfaßt.

11. Verfahren nach Anspruch 1, wobei der Schritt des Bereitstellens das Bereitstellen mindestens einer Parameterextrahiereinheit zur Durchführung des Schritts des Extrahierens umfaßt, wobei die mindestens eine Parameterextrahiereinheit eine linear-prädiktive Codierungseinheit enthält und der mindestens eine Parameter durch linear-prädiktive Codierungsbit repräsentiert wird.

12. Verfahren nach Anspruch 1, wobei die mindestens eine Parameterextrahiereinheit eine adaptive Codebucheinheit enthält und der mindestens eine Parameter durch adaptive Codebuchbit repräsentiert wird.

13. Verfahren nach Anspruch 1, wobei die mindestens eine Parameterextrahiereinheit eine adaptive Codebuchverstärkungseinheit enthält und der mindestens eine Parameter durch adaptive Codebuchverstärkungsbit repräsentiert wird.

14. Verfahren nach Anspruch 1, wobei der Schritt des Bereitstellens das Bereitstellen mindestens einer Parameterextrahiereinheit zur Durchführung des Schritts des Extrahierens umfaßt, wobei die mindestens eine Parameterextrahiereinheit eine linear-prädiktive Codierungseinheit, eine adaptive Codebucheinheit und eine adaptive Codebuchverstärkungseinheit enthält und der mindestens eine Parameter Parameter enthält, die durch linear-prädiktive Codierungsbit, adaptive Codebuchbit und adaptive Codebuchverstärkungsbit repräsentiert werden.

15. Verfahren nach Anspruch 1, wobei
der Schritt des Empfangens das Empfangen eines durch den Vocoder zu verarbeitenden Bitrahmens umfaßt;
der Schritt des Abänderns das Abändern eines vorbestimmten Signals in bezug auf erste Bit in dem Rahmen, die an dem abgeänderten Signal ankommen, umfaßt; und
das Verfahren weiterhin die folgenden Schritte umfaßt:
Indizieren eines Teils des abgeänderten Signals auf der Basis zweiter Bit in dem Rahmen; und
Bestimmen des indizierten Teils, so daß die Festcodebuchantwort für mindestens einen Teil des Bitrahmens repräsentiert wird.

16. Verfahren nach Anspruch 15, wobei die ersten Bit die linear-prädiktive Codierungsantwort für mindestens einen Teil des Bitrahmens repräsentieren.

17. Verfahren nach Anspruch 15, wobei die ersten Bit die linear-prädiktive Codierungsantwort, eine adaptive Codebuchantwort und eine adaptive Codebuchverstärkungsantwort für mindestens einen Teil des Bitrahmens repräsentieren.

18. Verfahren nach Anspruch 15, wobei der indizierte Teil eine Impulssequenz ist.

19. Verfahren nach Anspruch 18, wobei die Impulssequenz mehrere Nulleinträge und mehrere Impulseinträge enthält und das Verhältnis von Nulleinträgen zu Impulseinträgen im Bereich von 85 bis 95 Prozent liegt.

20. Verfahren nach Anspruch 15, wobei der Bitrahmen Unterrahmen enthält und der indizierte Teil die Festcodebuchantwort für einen der Unterrahmen des Bitrahmens repräsentiert.

## Revendications

1. Procédé de fonctionnement d'un vocodeur comprenant les étapes suivantes :
fourniture d'un livre de codes fixe (52) et d'un signal prédéterminé (53);
réception d'un signal d'entrée à traiter par le vocodeur;
extraction d'au moins un paramètre caractérisant le signal d'entrée;
altération du signal prédéterminé (53) en relation avec le ou les paramètres extraits pour parvenir à un signal altéré (58), **caractérisé par**
détermination d'une portion (60, 61, 62, 63, 64) du signal altéré (58) pour représenter une réponse de livre de codes fixe pour au moins une portion du signal d'entrée.

2. Procédé selon la revendication 1, dans lequel ladite étape de détermination comprend la comparaison d'un signal résiduel d'au moins une portion du signal d'entrée avec diverses portions du signal altéré et la détermination de celle des diverses portions qui correspond le mieux au signal résiduel.

3. Procédé selon la revendication 1, dans lequel le signal prédéterminé est un signal de bruit aléatoire gaussien.

4. Procédé selon la revendication 1, dans lequel une position indexée de la portion du signal altéré est **caractérisée par** une configuration binaire et incluse dans une trame binaire représentant le signal d'entrée.

5. Procédé selon la revendication 1, comprenant en outre la fourniture d'un filtre de pondération perceptif, dans lequel l'étape d'altération comprend le passage du signal prédéterminé à travers le filtre de pondération perceptif.

6. Procédé selon la revendication 5, dans lequel le filtre de pondération perceptif est un filtre actif influencé par une sortie de codage prédictif linéaire caractérisant au moins une portion du signal d'entrée.

7. Procédé selon la revendication 1, comprenant en outre la fourniture d'un filtre d'affinage de pas, dans lequel l'étape d'altération comprend le passage du signal prédéterminé à travers le filtre d'affinage de pas.

8. Procédé selon la revendication 7, dans lequel le filtre d'affinage de pas est un filtre actif influencé par une sortie de livre de codes adaptatif et une sortie de gain de livre de codes adaptatif, chacune caractérisant au moins une portion du signal d'entrée.

9. Procédé selon la revendication 1, comprenant en outre l'étape de filtrage du signal altéré avec un filtre à seuil avant ladite étape de détermination.

10. Procédé selon la revendication 1, comprenant en outre la fourniture d'un filtre de pondération perceptif, d'un filtre d'affinage de pas et d'un filtre à seuil, dans lequel ladite étape d'altération comprend le passage du signal prédéterminé à travers le filtre de pondération perceptif, le filtre d'affinage de pas et le filtre à seuil.

11. Procédé selon la revendication 1, dans lequel l'étape de fourniture comprend la fourniture d'au moins une unité d'extraction de paramètres pour exécuter l'étape d'extraction, l'unité ou les unités d'extraction de paramètres comprennent une unité de codage prédictif linéaire, et le ou les paramètres sont représentés par des bits de codage prédictif linéaire.

12. Procédé selon la revendication 1, dans lequel l'unité ou les unités d'extraction de paramètres comprennent une unité de livre de codes adaptatif, et le ou les paramètres sont représentés par des bits de livre de codes adaptatif.

13. Procédé selon la revendication 1, dans lequel l'unité ou les unités d'extraction de paramètres comprennent une unité de gain de livre de codes adaptatif, et le ou les paramètres sont représentés par des bits de gain de livre de codes adaptatif.

14. Procédé selon la revendication 1, dans lequel l'étape de fourniture comprend la fourniture d'au moins une unité d'extraction de paramètres pour exécuter l'étape d'extraction, l'unité ou les unités d'extraction de paramètres comprennent une unité de codage prédictif linéaire, une unité de livre de codes adaptatif, et une unité de gain de livre de codes adaptatif et le ou les paramètres comprennent des paramètres représentés par des bits de codage prédictif linéaire, des bits de livre de codes adaptatif et des bits de gain de livre de codes adaptatif.

15. Procédé selon la revendication 1, dans lequel :
l'étape de réception comprend la réception d'une trame binaire à traiter par le vocodeur;
l'étape d'altération comprend l'altération d'un signal prédéterminé en relation avec les premiers bits dans la trame à parvenir au signal altéré; et
le procédé comprend en outre :
l'indexation d'une portion du signal altéré sur la base de seconds bits dans la trame; et
la détermination de la portion indexée pour représenter la réponse de livre de codes fixe pour au moins une portion de la trame binaire.

16. Procédé selon la revendication 15, dans lequel les premiers bits représentent la réponse de codage prédictif linéaire pour au moins une portion de la trame binaire.

17. Procédé selon la revendication 15, dans lequel les premiers bits représentent la réponse de codage prédictif linéaire, une réponse de livre de codes adaptatif et une réponse de gain de livre de codes adaptatif pour au moins une portion de la trame binaire.

18. Procédé selon la revendication 15, dans lequel la portion indexée est une série d'impulsions.

19. Procédé selon la revendication 18, dans lequel la série d'impulsions comprend une pluralité d'entrées nulles et une pluralité d'entrées d'impulsions, et le rapport des entrées nulles sur les entrées d'impulsions est situé dans la plage de 85 à 95%.

20. Procédé selon la revendication 15, dans lequel lesdites trames binaires comprennent des sous-trames, et la portion indexée est représentative de la réponse de livre de codes fixe pour une des sous-trames de la trame binaire.
